# EUROPEAN PATENT SPECIFICATION

(11) **EP 3 565 088 B1**
(45) Date of publication and mention of the grant of the patent: **30.09.2026**
(21) Application number: 17886053.2
(22) Date of filing: 24.03.2017
(51) Int. Cl.: H02J 50/00, H02J 50/20

(54) **NOVEL ELECTRON SPIN-BASED RADIO FREQUENCY MICROWAVE ENERGY COLLECTING DEVICE**
NEUARTIGE VORRICHTUNG ZUR SAMMLUNG VON ELEKTRONENSPIN-BASIERTER HOCHFREQUENTER MIKROWELLENENERGIE
NOUVEAU DISPOSITIF DE COLLECTE D'ÉNERGIE MICRO-ONDES RADIOFRÉQUENCE À BASE DE SPIN ÉLECTRONIQUE

(30) Priority: 27.12.2016 CN 201611227721
(43) Date of publication of application: 06.11.2019
(73) Proprietor: Suzhou Institute of Nano-tech and Nano-bionics (SINANO) Chinese Academy of Sciences, Suzhou, Jiangsu 215123 (CN)
(72) Inventor: ZENG, Zhongming, Suzhou, Jiangsu 215123 (CN); GIOVANNI, Finocchio, Suzhou, Jiangsu 215123 (CN); FANG, Bin, Suzhou, Jiangsu 215123 (CN); CAI, Jialin, Suzhou, Jiangsu 215123 (CN); TANG, Wei, Suzhou, Jiangsu 215123 (CN); LUO, Xin, Suzhou, Jiangsu 215123 (CN); XIONG, Rongxin, Suzhou, Jiangsu 215123 (CN); ZHANG, Baoshun, Suzhou, Jiangsu 215123 (CN)
(74) Representative: Barker Brettell LLP
(86) International application number: PCT/CN2017/078000
(87) International publication number: WO 2018/120458

(56) References cited:
- WO-A1-2014/148719
- CN-A- 101 300 735
- CN-A- 101 527 420
- CN-A- 101 685 901
- CN-A- 105 223 414
- US-A1- 2011 044 096
- S{\L}AWOMIR ZI\K{E}TEK ET AL: "Rectification of radio frequency current in giant magnetoresistance spin valve", ARXIV.ORG, CORNELL UNIVERSITY LIBRARY, 201 OLIN LIBRARY CORNELL UNIVERSITY ITHACA, NY 14853, 24 October 2014 (2014-10-24), XP081393343, DOI: 10.1103/PHYSREVB.91.014430

## Description

### TECHNICAL FIELD

The present disclosure relates to a radio-frequency (RF)/microwave energy harvesting technology, especially to a new RF/microwave energy harvesting device based on spintronics.

### BACKGROUND ART

With rapid developments of a large-scale integrated circuit manufacturing technology and a hyperfine processing technology, a micro wireless sensor and a Micro-Electro-Mechanical system (MEMS) have been or will be widely applied to many fields, such as industry, agriculture, military, aeronautics and astronautics, medicine, environmental monitoring, family service and the like. At present, the wireless sensor and MEMS are powered by batteries or cables. However, in some applications, such as scattered wireless sensors mounted in the wild, it is impractical to supply power by batteries or cables. Especially, when the wireless sensors are powered by batteries, it is quite difficult to periodically replace a large number of batteries. Thus, energy supply is an important problem of the wireless sensor and MEMS to be solved.

Wireless charging is expected to solve the problem of energy supply for such applications. In the ambient condition, there are several kinds of electromagnetic wave energies, such as communication microwave energy, television signals, WiFi, etc. How to harvest and utilize those energies (namely, radio-frequency energy and microwave energy) to supply power for the wireless sensors and portable electronics has become an emerging issue. The current mainstream wireless energy harvesting technologies are based on electromagnetic induction or semiconductor diode, wherein the former has high conversion efficiency, but has limitations, such as short transmission distance and large size; and the latter has problems such as a small power capacity, a diode being easily broken down, high harmonics being generated and the like. Meanwhile, the above technologies are confronted with a narrow operating frequency and a size that is difficult to meet the miniaturization requirements.

WO 2014/148719 discloses an active RFID tag using a spin oscillator of extremely low power consumption with no additional battery mounted, characterized by including: an energy harvesting means for harvesting surrounding energy; at least one spin oscillator without an additional storage battery provided with the power generated from the harvesting means for generating an oscillation signal of a given frequency; and a spin modulator for modulating RFID data so as to output an RF signal by means of the oscillation signal outputted from the spin oscillator.

CN 105223414 discloses a microwave detector comprising a signal acquisition module, a rectifier module, a signal detection module and a signal display module, which are connected in turn, wherein the rectifier module comprises a fixed magnetic layer with in-plane balanced magnetization, a non-magnetic isolating layer formed on the fixed magnetic layer, and a magnetism free layer formed on the non-magnetic isolating layer and having vertical magnetocrystalline anisotropy.

CN 101300735 discloses a radio-frequency oscillator, which includes a magnetoresistive device in which a spin-polarised electric current flows. This device disclosed in '735 comprises a stack of at least: a first so-called "anchored" magnetic layer having a fixed magnetisation direction, a second magnetic layer, an amagnetic layer inserted between the above-mentioned two layers, intended to ensure magnetic decoupling of said layers. The oscillator also comprises means of causing a flow of electrons in said layers perpendicular to these layers and, if applicable, of applying an external magnetic field to the structure. The second magnetic layer has an excitation damping factor at least 10% greater than the damping measured in a simple layer of the same material having the same geometry for magnetic excitation having wavelengths equal to or less than the extent of the cone or cylinder of current that flows through the stack that constitutes the magnetoresistive device.

CN 101527420 discloses a current-driven symmetric magnetic multilayer-structure microwave oscillator in the field of microwave technology. The oscillator of '420 is characterized in that the current-driven symmetric magnetic multilayer-structure microwave oscillator is composed of two ferromagnetic films with the same thickness, between 2 nm and 6 nm. The two ferromagnetic films are separated by a thin non-magnetic layer which has a thickness between 1 nm and 3 nm (non-magnetic metal layer) or between 0.5 nm and 1.5 nm (insulating layer). The upper part and lower part of nanometer magnetic multilayer column are equally provided with a metal layer as an electrode. When a constant and invariable direct current vertically passes the magnetic multi-layer structure, the spin polarization and spin moment transmission are generated. The spin moment is exerted to each magnetic layer. When the current exceeds a threshold value, the alternate direction turnover of magnetization vectors of two magnetic films is caused, and furthermore the periodic changing of magnetic multilayer resistor is caused thereby generating stable microwave oscillation. The oscillation frequency and current have a linear relationship between 1-100GHz. The microwave power can also be adjusted by current between 1 microwatt and 1 milliwatt. The full-metallic structure accounts for 4%, and the magnetic channel structure accounts for 30%.

CN 101685901 discloses a spin microwave oscillator and a spin microwave detector. The spin microwave oscillator of '901 is directly controlled by direct current based on microwave oscillation and output of a spin angle momentum transfer principle, or jointly regulated and controlled by direct current and impressed static magnetic field. The spin microwave detector as disclosed in '901 directly detects input microwave by direct voltage generated by the input microwave.

US 2011/044096 discloses a magnetic tunnel junction (MTJ) structure that includes a bottom electrode, a fixed layer, a tunnel barrier layer, a free layer, and a top electrode. The bottom electrode is coupled to a bottom surface of the fixed layer and extends along at least one sidewall of the fixed layer.

*"Rectification of radio frequency current in giant magnetoresistance spin valve*" (Zi 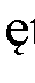 tek et al, 2014) discloses a spin diode effect in an exchange-biased spin-valve giant magnetoresistance (GMR) strips. In these multilayer structures, symmetry of the current distribution along the vertical direction is broken and, as a result, a non-compensated Oersted field acting on the magnetic free layer appears. This field, in turn, is a driving force of magnetization precessions. Due to the GMR effect, resistance of the strip oscillates following the magnetization dynamics. This leads to rectification of the applied radio frequency current and induces a direct current voltage VDC. Zi 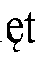 tek et al disclose a theoretical description of this phenomenon and calculate the spin diode signal, VDC, as a function of frequency, external magnetic field, and angle at which the external field is applied and disclose that the spin diode signal in GMR devices is significantly stronger than in the anisotropic magnetoresistance permalloy-based devices. Further background art can be found in US2008150643A1.

### SUMMARY

In order to overcome defects in the prior art, the present disclosure aims to provide a new radio-frequency (RF)/microwave energy harvesting device based on spintronics, thereby providing a power generation device having a simple structure and capable of harvesting the RF/microwave energy and converting the RF/microwave energy into DC electric energy.

According to a first aspect of the present invention, there is provided a RF/microwave energy harvesting device based on spintronics as described in claim 1. Some optional or preferred features are defined in the dependent claims.

According to the present disclosure, a new RF/microwave energy harvesting device based on spintronics is provided. The device comprises at least one RF/microwave energy conversion element comprising a first magnetic layer connected to a RF/microwave signal receiving element; a non-magnetic space layer; and another magnetic layer, namely, an energy conversion layer accumulating positive and negative charges at upper and lower ends of the RF/microwave energy conversion element to convert a RF/microwave energy into a direct voltage signal. Compared with the prior art, the device has advantages such as simple structure, small size, wide operating frequency, etc .

Further, the space layer is provided on the first magnetic layer, and the energy conversion layer is provided on the space layer.

Further, the first magnetic layer comprises: an anti-ferromagnetic layer; at least two second magnetic layers provided on the anti-ferromagnetic layer; and a metal layer provided between two adjacent ones of the second magnetic layers.

Further, the first magnetic layer includes at least two first magnetic layers, the energy conversion layer is provided between two adjacent ones of the first magnetic layers, and the space layer is provided between the first magnetic layers and the energy conversion layer.

Further, the energy conversion layer includes at least two energy conversion layers, and the space layer is provided between two adjacent ones of the energy conversion layers.

Further, the space layer is made of a metal or an insulating material.

Further, when the space layer is made of a metal material, the metal material is one of copper and silver; and when the space layer is made of an insulating material, the insulating material is one of magnesium oxide, aluminum oxide and the like.

Further, when the space layer is made of the metal material, the space layer has a thickness of 0.5nm-5nm; and when the space layer is made of the insulating material, the space layer has a thickness of 0.5nm-3nm.

Further, the energy conversion layer is made of a magnetic material which is at least one of NiFe, Fe, Co, FeB, CoFeB, Co/Pt, Co/Pd, Co/Ni, CoFeSiB and TeFeCoAl.

Further, the RF/microwave energy conversion element includes two or more RF/microwave energy conversion elements, and the RF/microwave energy conversion elements are connected to each other in series or in parallel.

Compared with the prior art, the new RF/microwave energy harvesting device based on spintronics according to the present disclosure has advantages such as simple structure, small size, wide operating frequency range and high energy conversion efficiency per unit area; and the new RF/microwave energy harvesting device based on spintronics according to the present disclosure is operated under a room temperature, has no requirement for the environment where electromagnetic energy will be harvested, and may be applied to various fields such as wireless charging, electromagnetic energy harvesting and the like.

### BRIEF DESCRIPTION OF THE DRAWINGS

FIG. 1 is a structure schematic diagram according to the present disclosure.
FIG. 2 is a structure schematic diagram of a first example of a RF/microwave energy conversion element according to the present disclosure.
FIG. 3 is a structure schematic diagram of a second example of a RF/microwave energy conversion element according to the present disclosure.
FIG. 4 is a structure schematic diagram of a third example of a RF/microwave energy conversion element according to the present disclosure.
FIG. 5 is a structure schematic diagram of a fourth example of a RF/microwave energy conversion element according to the present disclosure.
FIG. 6A is a structure schematic diagram of a fifth example 5 of a RF/microwave energy conversion element according to the present disclosure.
FIG. 6B is a RF/microwave energy harvesting performance diagram of the fifth example according to the present disclosure.
FIG. 7 is a structure schematic diagram of a sixth example of a RF/microwave energy conversion element according to the present disclosure.
FIG. 8 is a structure schematic diagram of a seventh example of a RF/microwave energy conversion element according to the present disclosure.
FIG. 9 is a structure schematic diagram of a eighth example of a RF/microwave energy conversion element according to the present disclosure.
FIG. 10 is a structure schematic diagram of a first embodiment of a RF/microwave energy conversion element according to the present disclosure.
FIG. 11 is a structure schematic diagram of a second embodiment of a RF/microwave energy conversion element according to the present disclosure.
FIG. 12 is a structure schematic diagram of a third embodiment of a RF/microwave energy conversion element according to the present disclosure.
FIG. 13 is a schematic diagram of a RF/microwave energy conversion element being connected in series in a nano power generation device according to the present disclosure.
FIG. 14 is a schematic diagram of a RF/microwave energy conversion element being connected in parallel in a nano power generation device according to the present disclosure.

### DETAILED DESCRIPTION OF EXEMPLARY EMBODIMENTS

Hereinafter, the present disclosure will be further described with reference to the figures and embodiments.

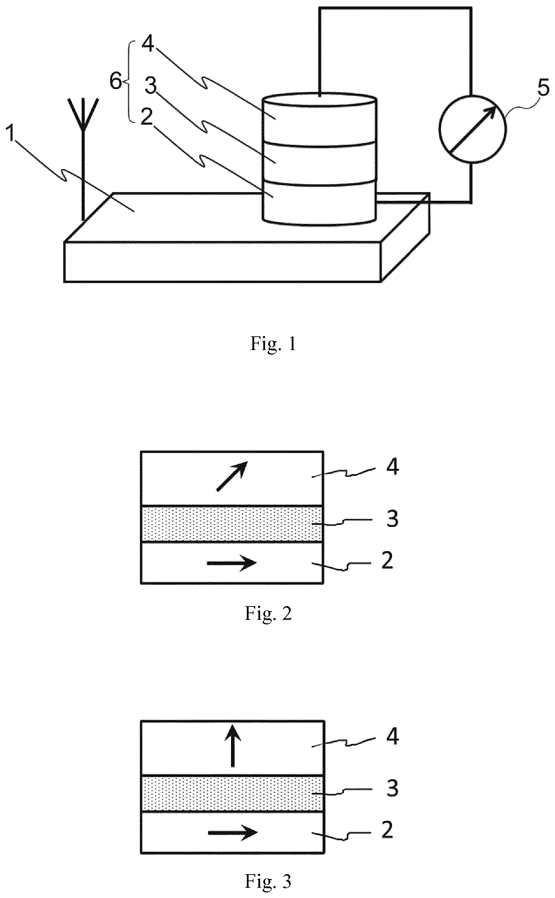

As shown in FIG. 1, a new RF/microwave energy harvesting device based on spintronics according to the present disclosure includes at least one RF/microwave energy conversion element 6 for converting RF/microwave energy into a direct voltage signal.

The RF/microwave energy conversion element 6 at least includes a first magnetic layer 2 which has a fixed in-plane magnetization axis, a non-magnetic space layer 3 and an energy conversion layer 4, wherein the first magnetic layer 2 is connected to a RF/microwave signal receiving element 1, and the energy conversion layer 4 accumulates positive and negative charges at both of upper and lower ends of the RF/microwave energy conversion element 6 to implement the conversion of a RF/microwave energy into a direct voltage signal.

Acquisition of a signal of the RF/microwave energy conversion element 6 may be implemented by the RF/microwave signal receiving element 1 connected thereto, the RF/microwave energy conversion element 6 may generate a direct voltage signal to be output to an external circuit 5, and the external circuit 5 is connected to the both ends of the RF/microwave energy conversion element 6, respectively, and is a device for harvesting a direct voltage signal, such as a storage battery and the like, or a transformer, thereby producing a function of power supply. Since the kinds of the external circuit 5 is not unique, and may be changed according to actual practice, which is not particularly defined here.

The first magnetic layer 2 of the fixed in-plane magnetization axis indicates that a magnetization (magnetic moment) orientation of the magnetic layer is along a direction of a film plane, and the word "fixed" indicates the direction of magnetic moment not to be easily changed.

The magnetic moment orientation of the energy conversion layer 4 is determined with respect to the direction of the film plane of the first magnetic layer 2 and includes out-of-plane orientation due to oblique to the film plane of the first magnetic layer 2, in-plane orientation due to being parallel to the film plane of the first magnetic layer 2 and out-of-plane orientation due to being perpendicular to the film plane of the first magnetic layer 2, wherein the out-of-plane orientation indicates an angle between the magnetic moment of the energy conversion layer 4 and the film plane of the first magnetic layer 2 to be larger than zero; and the in-plane orientation indicates an angle between the magnetic moment of the energy conversion layer 4 and the film plane of the first magnetic layer 2 to be equal to zero.

For the magnetic thin film, there are several factors to determine its intrinsic magnetic moment orientation: shape anisotropic field, magnetocrystalline anisotropic field, demagnetization field and stray field. Generally, there are two common situations where the orientation is lying in the film plane or perpendicular to the thin film. Recent work finds that the amplitude and direction of the magnetocrystalline anisotropic field may be effectively controlled by adjusting the film thickness and interface characteristics between the magnetic thin films, thereby resulting in the magnetic moment orientation oblique to the film plane. This state is cone-shaped mentioned in the present patent. More specific, in the cone state, the amplitude of the first-order magnetocrystalline anisotropic field is proximity to the amplitude of the demagnetization field while their directions are opposite. In this case, the effective saturation magnetization amplitude of the magnetic thin film is reduced, and the second-order magnetocrystalline anisotropic field plays a dominant role. This cone state (that is, the canted magnetic moment orientation) has the following advantages: first, low critical current density required for procession of magnetic moment; second, easy realization of the large-amplitude out-of-plane procession. These advantages make such a magnetic structure be used as the energy conversion layer with high energy conversion efficiency under low-power RF/microwave energy.

The RF/microwave signal receiving element 1 mainly includes an antenna, a RF/microwave conduction element connected with the antenna and an impedance matcher connected with the RF/microwave conduction element. The impedance matcher is connected with the first magnetic layer 2 of the RF/microwave energy conversion element 6, and the specific definition is not made here.

According to the present disclosure, large-amplitude procession of the magnetic moment in the energy conversion layer 4 of the RF/microwave energy conversion element 6 is induced by collecting external RF/microwave signal with the RF/microwave signal receiving element 1. Since the magnetic multi-layer film structure has a giant magnetoresistance effect, positive and negative charges are accumulated at both of upper and lower ends of the RF/microwave energy conversion element 6 and the accumulated positive and negative charges are output to the external circuit 5 to implement the conversion of the RF/microwave signal into a direct voltage signal.

The range of the frequency of the RF/microwave signal receiving element 1 received is 0.1MHz-10GHz.

The first magnetic layer 2 according to the present disclosure is a pinned magnetic layer which is constituted by at least one magnetic thin film. Amplitude of a coercive field of the magnetic thin film is 5mT-1500mT. The space layer 3 is made of a metal or an insulating material. The space layer 3 may be made of a metal material, such as one of copper (Cu) and silver (Ag), and a thickness thereof is 0.5nm-5nm. Alternatively, the space layer 3 may be made of an insulating material, such as one of magnesium oxide (MgO) and aluminum oxide, and a thickness thereof is 0.5nm-3nm. The energy conversion layer 4 is made of a magnetic material, such as at least one of NiFe, Fe, Co, FeB, CoFeB, Co/Pt, Co/Pd, Co/Ni, CoFeSiB and TeFeCoAl, wherein Co/Pt, Co/Pd and Co/Ni are laminated materials and the rest are all alloy materials.

The above structure has the following advantages: a magnetic tunnel junction multilayer film composed of MgO single-crystal barrier layer has a comparatively giant tunneling magnetoresistance effect and may improve energy conversion efficiency; and the energy conversion layer 4 having a canted magnetic moment orientation may implement high energy conversion efficiency under low- power RF/microwave energy.

As illustrated in FIG. 2, in the first example, a laminated structure of the RF/microwave energy conversion element 6 is as follows: the space layer 3 is provided on the first magnetic layer 2, and the energy conversion layer 4 is provided on the space layer 3. A magnetization direction of the energy conversion layer 4 is perpendicular to the magnetization direction of the first magnetic layer 2, and an angle between magnetization directions of the energy conversion layer 4 and the first magnetic layer 2 is equal to 90 degrees in the absence of an external magnetic field.

As illustrated in FIG. 3, in the second example, a laminated structure of the RF/microwave energy conversion element 6 is as follows: the space layer 3 is provided on the first magnetic layer 2, and the energy conversion layer 4 is provided on the space layer 3. A magnetization direction of the energy conversion layer 4 is oblique to the magnetization direction of the thin film of the first magnetic layer 2, and the magnetization directions of the energy conversion layer 4 are oblique to the film plane of first magnetic layer 2 in the absence of an external magnetic field.

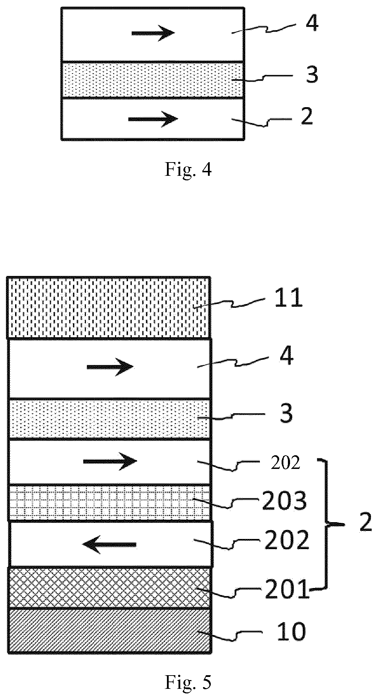

As illustrated in FIG. 4, in the third example, a laminated structure of the RF/microwave energy conversion element 6 is as follows: the space layer 3 is provided on the first magnetic layer 2, and the energy conversion layer 4 is provided on the space layer 3. The magnetization direction of the energy conversion layer 4 is parallel to the film plane of the first magnetic layer 2, and the magnetization directions of the energy conversion layer 4 and the first magnetic layer 2 are parallel to the film plane of first magnetic layer 2 in the absence of an external magnetic field.

As illustrated in FIG. 5, in the fourth example, a laminated structure of the RF/microwave energy conversion element 6 is as follows: the space layer 3 is provided on the first magnetic layer 2, and the energy conversion layer 4 is provided on the space layer 3, wherein the first magnetic layer 2 is constituted by laminating multilayer thin films. The first magnetic layer 2 includes an anti-ferromagnetic layer 201, two second magnetic layers 202 provided on the anti-ferromagnetic layer 201 and a metal layer 203 provided between the two adjacent second magnetic layers 202. The space layer 3 is provided on the uppermost one of the second magnetic layers 202, and the energy conversion layer 4 is provided on the space layer 3.

In the present embodiment, the magnetic moment directions of the two second magnetic layers 202 are parallel to an in-plane, that is, parallel to the film plane of the second magnetic layer 202, but the magnetic moment directions of the two second magnetic layers 202 are opposite. The magnetic moment direction of the energy conversion layer 4 is parallel to and opposite to the magnetic moment direction the uppermost one of the second magnetic layers 202.

In the fourth example, a metal buffer layer 10 may be disposed on a lower end of the first magnetic layer 2 and a metal cap 11 is disposed on the energy conversion layer 4.

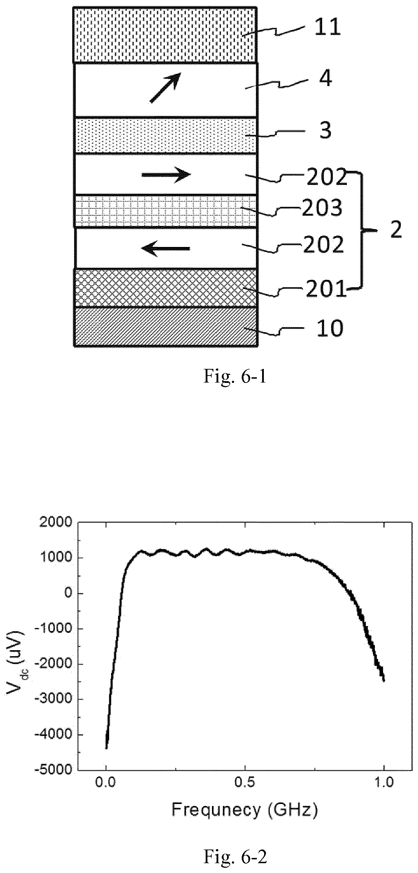

As illustrated in FIG. 6A, the fifth example is different from the fourth example only in that the magnetic moment direction of the energy conversion layer 4 is oblique to the magnetic moment direction of the uppermost one of the second magnetic layers 202, that is, oblique to the film plane of the second magnetic layer 202.

As an optimal solution of the present disclosure, the structure of the RF/microwave energy conversion element includes a magnetic layer 2 which has a fixed in-plane magnetization axis and is composed of four magnetic thin films PtMn with a film thickness of 15nm, Co₇₀Fe₃₀ with a film thickness of 2.3nm, Ru with a film thickness of 0.85nm and Co₄₀Fe₄₀B₂₀ with a film thickness of 2.4nm, a non-magnetic layer 3 including magnesium oxide (MgO) with a film thickness of 0.8nm, and an energy conversion layer 4 including Co₂₀Fe₆₀B₂₀ having an canted magnetic moment orientation with a thickness of 1.53nm, wherein PtMn, CoFe and CoFeB are all alloy materials, wherein subscripts of Co₇₀Fe₃₀, Co₄₀Fe₄₀B₂₀ and Co₂₀Fe₆₀B₂₀ refers to mass ratios of the alloy materials. The cross section of the RF/microwave energy conversion element has an ellipse shape with a long axis of 150nm and a short axis of 60nm. A performance test result according to the optimal embodiment is shown in FIG.6B. In a frequency range of the RF/microwave of 0.1MHz-1GHz, a RF/microwave signal has a power of 32µW. That is, it is observed that stable direct current converted energy is output within a very wide frequency range.

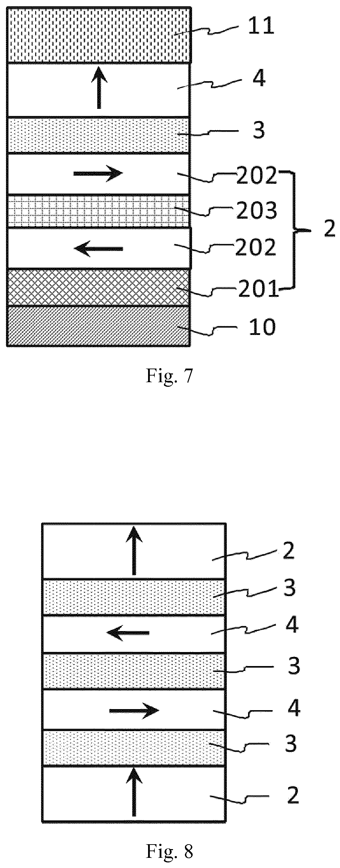

As illustrated in FIG. 7, the sixth example is different from the fourth example only in that the magnetic moment direction of the energy conversion layer 4 is perpendicular to the magnetic moment direction of the uppermost one of the second magnetic layers 202, that is, perpendicular to the film plane of the second magnetic layer 202.

As illustrated in FIG. 8, in the seventh example, there are two first magnetic layers 2 and two energy conversion layer 4 in the RF/microwave energy conversion element 6. The energy conversion layer 4 is provided between the two first magnetic layers 2. There is a space layer 3 between the first magnetic layers 2 and the energy conversion layers 4, and there is another space layer 3 between the two adjacent energy conversion layers 4.

In the present example, the magnetic moment direction of the first magnetic layer 2 is perpendicular to in-plane, that is, perpendicular to the film plane thereof. The magnetic moment directions of the energy conversion layers 4 are both parallel to in-plane, that is, parallel to the film plane of the first magnetic layer 2, and opposing to each other.

In the above the fourth example to the seventh example, the second magnetic layer 202 has a magnetic film structure, particularly, the second magnetic layer 202 is made of a ferromagnetic material; and the metal layer 203 is made of ruthenium or copper; and the anti-ferromagnetic layer 201 is made of IrMn or PtMn.

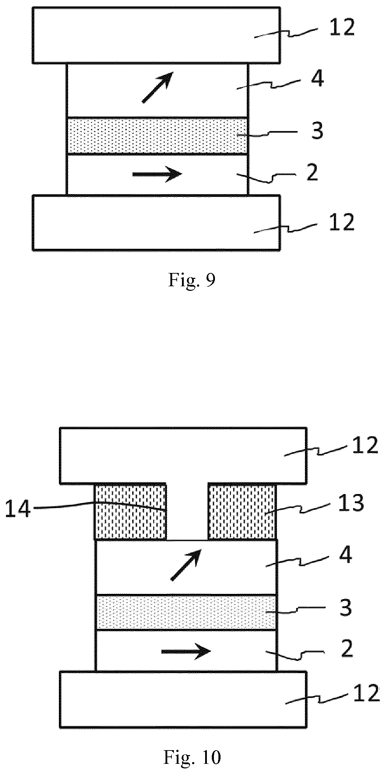

As illustrated in FIG. 9, the eighth example differs from the first to third examples in that a metal electrode 12 may be further provided on the first magnetic layer 2 and the energy conversion layer 4, respectively. Here, the RF/microwave energy conversion element 6 has a columnar structure with a lateral size ranging from 50nm to 500nm by etching. The magnetoresistance effect of the RF/microwave energy conversion element 6 is comparatively strong due to such a columnar structure so as to be helpful to improve the RF/microwave energy conversion efficiency.

As illustrated in FIG. 10, the first embodiment differs from the eighth example in that: an insulating dielectric layer 13 is disposed on the energy conversion layer 4, and the uppermost one of the metal electrodes 12 is electrically connected to the energy conversion layer 4 through at least one nano-hole 14 formed by etching the insulating dielectric layer 13, and thus a nano-point contact structure is formed. In the present embodiment, only one nano-hole 14 is provided, and an aperture of the nano-hole 14 is 30nm-300nm. Although the magnetoresistance effect of the ninth embodiment is weaker than that of the eighth embodiment with the columnar structure, due to such a nano-point contact structure, the ninth embodiment easily implements synchronization of a RF/microwave signal and is also helpful to improve the microwave energy conversion efficiency.

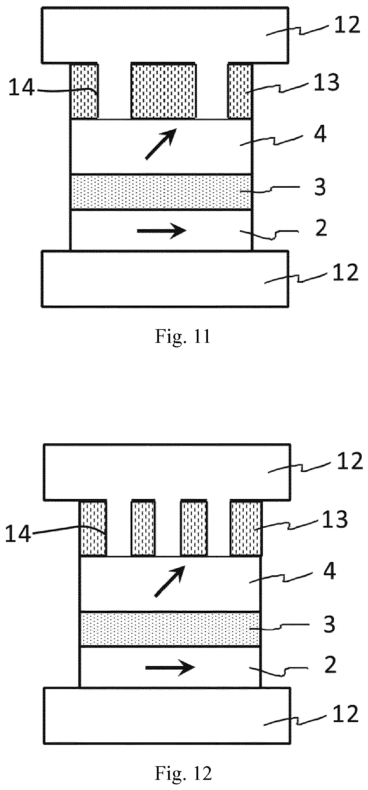

As illustrated in FIG. 11, the second embodiment differs from the first embodiment mainly in that two nano-holes 14 are provided and a distance between the two nano-holes 14 is 50nm-2000nm.

As illustrated in FIG. 12, the third embodiment differs from the first embodiment mainly in that three nano-holes 14 are provided and a distance between adjacent two one of the nano-holes 14 is 50nm-2000nm.

The RF/microwave energy conversion element 6 according to the present disclosure may generate direct voltage signals at both ends thereof. As a broadband RF/microwave energy harvesting device, The RF/microwave energy conversion element 6 according to the present disclosure can collect RF/microwave energy from the external space and convert the RF/microwave energy into direct voltage signals. The frequency range of the collected energy is relatively wide, that is, more RF/microwave energy may be harvested and converted. Conversion efficiency is defined as: Output DC power divided by Input RF/microwave power.

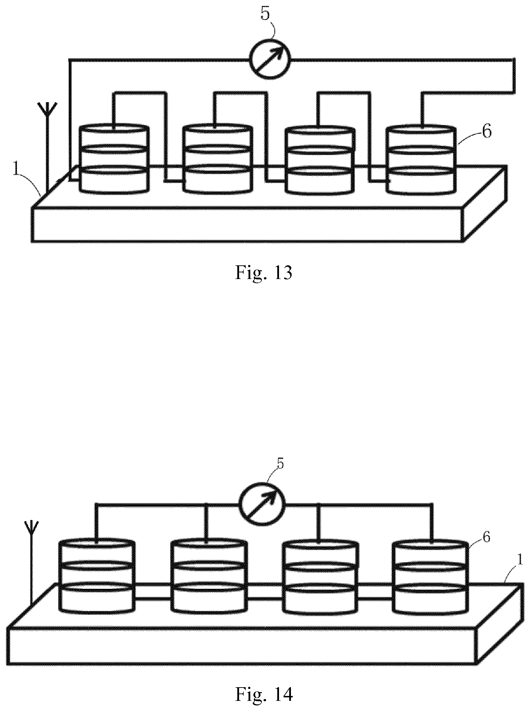

As illustrated in FIG. 13, as an optimal embodiment according to the present disclosure, four RF/microwave energy conversion elements 6 are provided, and four RF/microwave energy conversion elements 6 are connected to the external circuit 5 in series. As illustrated in FIG. 14, the RF/microwave energy conversion elements 6 are connected to each other in parallel, which can harvest RF/microwave signals having higher energy.

After being connected in series or parallel in the present disclosure, a plurality of RF/microwave energy conversion elements 6 are encapsulated as a modular assembly.

A power generation method of the broadband RF/microwave energy harvesting device according to the present disclosure includes:
RF/microwave signal is received through a RF/microwave conduction element and an impedance matching element of the external RF/microwave signal receiving element 1 and transmitted to the RF/microwave energy receiving element 6;
After the RF/microwave energy conversion element 6 has received the RF/microwave signal, the RF/microwave signal makes the magnetic moment of the energy conversion layer 4 in the RF/microwave energy conversion element 6 be rotated;
The magnetic moment is rotated such that positive and negative charges be accumulated on the upper and lower ends of the RF/microwave energy conversion element 6; and
The accumulated positive and negative charges are output to the external circuit 5 to implement the conversion of the RF/microwave energy into a direct voltage signal.

The broadband RF/microwave energy harvesting device according to the present disclosure may be used to harvesting microwave energy which will be stored through an energy storage device such as a mobile power source, and a wireless charging device may be formed by combining the RF/microwave energy harvesting device according to the present disclosure with a wireless charging coil, which may be wirelessly connected with a mobile phone, thereby solving the charging problem of the mobile phone .

The broadband RF/microwave energy harvesting device according to the present disclosure can harvest RF/microwave energy of different frequency bands from the external space. The broadband RF/microwave energy harvesting device according to the present disclosure can be applied to the wireless charging field, which is the greatest advantage thereof. Specifically, for example, the broadband RF/microwave energy harvesting device according to the present disclosure can be integrated with a chip in a mobile phone, to wirelessly charging by converting energy of WiFi wireless signal.

The broadband RF/microwave energy harvesting device according to the present disclosure, which is a nano power generation device, is suitable for various application.

By aiming at improving defects of complicated circuit structure, large size, narrow capturable frequency range, short transmission distance and the like in the general wireless charging technologies and electromagnetic energy harvesting technologies, the present disclosure provides a nano power generation device which converts electromagnetic energy into electric energy under a relatively wide frequency range (0.1MHz-10GHz). The nano power generation device has advantages such as small size (i.e., in nanometer, much smaller than a semiconductor-based energy conversion structure), wide operating frequency range, high energy conversion efficiency per unit area, long transmission distance and so on.

## Claims

1. A RF/microwave energy harvesting device based on spintronics, comprising:
at least one RF/microwave energy conversion element (6) having a giant magnetoresistance effect,
wherein the RF/microwave energy conversion element comprises:
a first magnetic layer (2) connected to a RF/microwave signal receiving element (1);
either a non-magnetic space layer (3) made of one of copper and silver and having a thickness of 0.5nm-5nm, or a non-magnetic space layer made of one of magnesium oxide and aluminum oxide and having a thickness of 0.5nm-3nm;
an energy conversion layer (4) made from one or a combination of magnetic materials that accumulates positive and negative charges at both of upper and lower ends of the RF/microwave energy conversion element to implement a conversion of a RF/microwave energy into a direct voltage signal and **characterized in that** the RF microwave energy conversion element further comprises;
an insulating dielectric layer (13) disposed on the energy conversion layer (4);
a first metal electrode (12) disposed on the insulating dielectric layer (13); and
a second metal electrode (12) disposed adjacent the first magnetic layer (2)
wherein the first metal electrode (12) is electrically connected to the energy conversion layer through at least one nano-hole (14) in the insulating dielectric layer (13).

2. The RF/microwave energy harvesting device based on spintronics of claim 1, wherein
the space layer (3) is provided on the first magnetic layer (2), and the energy conversion layer (4) is provided on the space layer.

3. The RF/microwave energy harvesting device based on spintronics of claim 2, wherein the first magnetic layer (2) comprises:
an anti-ferromagnetic layer (201);
at least two second magnetic layers (202) provided on the anti-ferromagnetic layer; and
a metal layer (203) provided between two adjacent ones of the second magnetic layers.

4. The RF/microwave energy harvesting device based on spintronics of claim 1, wherein
the first magnetic layer (2) includes at least two first magnetic layers (202), the energy conversion layer (4) is provided between two adjacent ones of the first magnetic layers, and the space layer (3) is provided between the first magnetic layers and the energy conversion layer.

5. The RF/microwave energy harvesting device based on spintronics of claim 4, wherein
the energy conversion layer (4) includes at least two energy conversion layers, and the space layer (3) is provided between two adjacent ones of the energy conversion layers.

6. The RF/microwave energy harvesting device based on spintronics of claim 1, wherein
the energy conversion layer (4) is made of a magnetic material which is at least one of NiFe, Fe, Co, FeB, CoFeB, Co/Pt, Co/Pd, Co/Ni, CoFeSiB and TeFeCoAl.

7. The RF/microwave energy harvesting device based on spintronics of claim 1, wherein
the RF/microwave energy conversion element (6) includes two or more RF/microwave energy conversion elements, and the RF/microwave energy conversion elements are connected to each other in series or in parallel.

## Patentansprüche

1. Vorrichtung zur Gewinnung von HF-/Mikrowellenenergie basierend auf Spintronik, umfassend:
mindestens ein Element (6) zur Umwandlung von HF-/Mikrowellenenergie, das einen riesigen Magnetowiderstandseffekt aufweist,
wobei das Element zur Umwandlung von HF-/Mikrowellenenergie Folgendes umfasst:
eine erste magnetische Schicht (2), die mit einem Element (1) zu Empfangen von HF-/Mikrowellensignalen verbunden ist;
entweder eine nichtmagnetische Raumschicht (3), die aus einem von Kupfer und Silber hergestellt ist und eine Dicke von 0,5 nm-5 nm aufweist, oder eine nichtmagnetische Raumschicht, die aus einem von Magnesiumoxid und Aluminiumoxid hergestellt ist und eine Dicke von 0,5 nm-3 nm aufweist;
eine Energieumwandlungsschicht (4), die aus einem oder einer Kombination von magnetischen Materialien hergestellt ist, die positive und negative Ladungen an sowohl dem oberen als auch dem unteren Ende des Elements zur Umwandlung von HF-/Mikrowellenenergie akkumuliert, um eine Umwandlung einer HF-/Mikrowellenenergie in ein Gleichspannungssignal umzusetzen, und **dadurch gekennzeichnet, dass** das Element zur Umwandlung von HF-Mikrowellenenergie ferner Folgendes umfasst;
eine isolierende dielektrische Schicht (13), die auf der Energieumwandlungsschicht (4) angeordnet ist;
eine erste Metallelektrode (12), die auf der isolierenden dielektrischen Schicht (13) angeordnet ist; und
eine zweite Metallelektrode (12), die benachbart zu der ersten magnetischen Schicht (2) angeordnet ist,
wobei die erste Metallelektrode (12) über mindestens ein Nanoloch (14) in der isolierenden dielektrischen Schicht (13) elektrisch mit der Energieumwandlungsschicht verbunden ist.

2. Vorrichtung zur Gewinnung von HF-/Mikrowellenenergie basierend auf Spintronik nach Anspruch 1, wobei
die Raumschicht (3) auf der ersten magnetischen Schicht (2) bereitgestellt ist und die Energieumwandlungsschicht (4) auf der Raumschicht bereitgestellt ist.

3. Vorrichtung zur Gewinnung von HF-/Mikrowellenenergie basierend auf Spintronik nach Anspruch 2, wobei die erste magnetische Schicht (2) Folgendes umfasst:
eine antiferromagnetische Schicht (201);
mindestens zwei zweite magnetische Schichten (202), die auf der antiferromagnetischen Schicht bereitgestellt sind; und
eine Metallschicht (203), die zwischen zwei benachbarten der zweiten magnetischen Schichten bereitgestellt ist.

4. Vorrichtung zur Gewinnung von HF-/Mikrowellenenergie basierend auf Spintronik nach Anspruch 1, wobei
die erste magnetische Schicht (2) mindestens zwei erste magnetische Schichten (202) beinhaltet, die Energieumwandlungsschicht (4) zwischen zwei benachbarten der ersten magnetischen Schichten bereitgestellt ist und die Raumschicht (3) zwischen den ersten magnetischen Schichten und der Energieumwandlungsschicht bereitgestellt ist.

5. Vorrichtung zur Gewinnung von HF-/Mikrowellenenergie basierend auf Spintronik nach Anspruch 4, wobei
die Energieumwandlungsschicht (4) mindestens zwei Energieumwandlungsschichten beinhaltet und die Raumschicht (3) zwischen zwei benachbarten der Energieumwandlungsschichten bereitgestellt ist.

6. Vorrichtung zur Gewinnung von HF-/Mikrowellenenergie basierend auf Spintronik nach Anspruch 1, wobei
die Energieumwandlungsschicht (4) aus einem magnetischen Material hergestellt ist, welches mindestens eines von NiFe, Fe, Co, FeB, CoFeB, Co/Pt, Co/Pd, Co/Ni, CoFeSiB und TeFeCoAl ist.

7. Vorrichtung zur Gewinnung von HF-/Mikrowellenenergie basierend auf Spintronik nach Anspruch 1, wobei
das Element (6) zur Umwandlung von HF-/Mikrowellenenergie zwei oder mehrere Elemente zur Umwandlung von HF-/Mikrowellenenergie beinhaltet und die Elemente zur Umwandlung von HF-/Mikrowellenenergie miteinander in Reihe oder parallel geschaltet sind.

## Revendications

1. Dispositif de collecte d'énergie RF/micro-ondes basé sur la spintronique, comprenant :
au moins un élément de conversion d'énergie RF/micro-ondes (6) présentant un effet de magnétorésistance géante,
dans lequel l'élément de conversion d'énergie RF/micro-ondes comprend :
une première couche magnétique (2) reliée à un élément de réception de signal RF/micro-ondes (1) ;
soit une couche d'espacement non magnétique (3) constituée de cuivre ou d'argent et ayant une épaisseur de 0,5 nm à 5 nm, soit une couche d'espacement non magnétique constituée d'oxyde de magnésium ou d'oxyde d'aluminium et ayant une épaisseur de 0,5 nm à 3 nm ;
une couche de conversion d'énergie (4) constituée d'un matériau ou d'une combinaison de matériaux magnétiques qui accumule des charges positives et négatives aux extrémités supérieure et inférieure de l'élément de conversion d'énergie RF/micro-ondes afin de convertir l'énergie RF/micro-ondes en un signal de tension continue, et **caractérisé en ce que** l'élément de conversion d'énergie RF/micro-ondes comprenne en outre :
une couche diélectrique isolante (13) disposée sur la couche de conversion d'énergie (4) ;
une première électrode métallique (12) disposée sur la couche diélectrique isolante (13) ; et
une seconde électrode métallique (12) disposée de manière adjacente à la première couche magnétique (2),
dans lequel la première électrode métallique (12) est reliée électriquement à la couche de conversion d'énergie à travers au moins un nano-trou (14) dans la couche diélectrique isolante (13).

2. Dispositif de collecte d'énergie RF/micro-ondes basé sur la spintronique selon la revendication 1, dans lequel
la couche d'espacement (3) est prévue sur la première couche magnétique (2), et la couche de conversion d'énergie (4) est prévue sur la couche d'espacement.

3. Dispositif de collecte d'énergie RF/micro-ondes basé sur la spintronique selon la revendication 2, dans lequel la première couche magnétique (2) comprend :
une couche antiferromagnétique (201) ;
au moins deux secondes couches magnétiques (202) prévues sur la couche antiferromagnétique ; et
une couche métallique (203) prévue entre deux couches adjacentes parmi les secondes couches magnétiques.

4. Dispositif de collecte d'énergie RF/micro-ondes basé sur la spintronique selon la revendication 1, dans lequel
la première couche magnétique (2) comprend au moins deux premières couches magnétiques (202), la couche de conversion d'énergie (4) est prévue entre deux couches adjacentes parmi les premières couches magnétiques, et la couche d'espacement (3) est prévue entre les premières couches magnétiques et la couche de conversion d'énergie.

5. Dispositif de collecte d'énergie RF/micro-ondes basé sur la spintronique selon la revendication 4, dans lequel
la couche de conversion d'énergie (4) comprend au moins deux couches de conversion d'énergie, et la couche d'espacement (3) est prévue entre deux couches adjacentes parmi les couches de conversion d'énergie.

6. Dispositif de collecte d'énergie RF/micro-ondes basé sur la spintronique selon la revendication 1, dans lequel
la couche de conversion d'énergie (4) est constituée d'un matériau magnétique choisi parmi au moins un des éléments suivants : le NiFe, le Fe, le Co, le FeB, le CoFeB, le Co/Pt, le Co/Pd, le Co/Ni, le CoFeSiB et le TeFeCoAl.

7. Dispositif de collecte d'énergie RF/micro-ondes basé sur la spintronique selon la revendication 1, dans lequel
l'élément de conversion d'énergie RF/micro-ondes (6) comprend deux éléments de conversion d'énergie RF/micro-ondes ou plus, et les éléments de conversion d'énergie RF/micro-ondes sont reliés les uns aux autres en série ou en parallèle.
